Europäisches Patentamt

European Patent Office

Office européen des brevets

(11) Publication number: **0 018 173**
**B1**

(12) **EUROPEAN PATENT SPECIFICATION**

(45) Date of publication of patent specification: **22.08.84**

(21) Application number: **80301154.3**

(22) Date of filing: **10.04.80**

(51) Int. Cl.³: **H 01 L 27/08**, H 01 L 29/54, G 11 C 17/00

(54) A programmable read-only memory device.

(30) Priority: **13.04.79 JP 45135/79**

(43) Date of publication of application:
**29.10.80 Bulletin 80/22**

(45) Publication of the grant of the patent:
**22.08.84 Bulletin 84/34**

(84) Designated Contracting States:
**DE FR GB NL**

(56) References cited:
**FR-A-2 369 652**
**US-A-3 843 425**
**US-A-4 125 880**
**PATENT ABSTRACTS OF JAPAN, vol. 2, no. 108, August 23, 1978, page 5289E78, TOKYO (JP)**
**PATENT ABSTRACTS OF JAPAN, vol. 3, no. 15, February 9, 1979, page 119E89, TOKYO (JP)**
**PATENT ABSTRACTS OF JAPAN, vol. 2, no. 82, June 30, 1978, page 3411E78, TOKYO (JP)**
**PATENT ABSTRACTS OF JAPAN, vol. 1, no. 143, November 22, 1977, page 7059E77, TOKYO (JP)**

(73) Proprietor: **FUJITSU LIMITED,**
**1015, Kamikodanaka Nakahara-ku**
**Kawasaki-shi Kanagawa 211 (JP)**

(72) Inventor: **Fukushima, Toshitaka**
**1604-442, Shiomidai**
**Isogo-ku Yokohama-shi Kanagawa (JP)**
Inventor: **Koyama, Kazumi**
**3-17-7 Wakabadai**
**Shiroyama-cho Tsukui-gun Kanagawa (JP)**
Inventor: **Ueno, Kouji**
**1360 Shukugawara**
**Tama-ku Kawasaki-shi Kanagawa (JP)**

(74) Representative: **Rackham, Stephen Neil et al**
**GILL JENNINGS & EVERY 53-64 Chancery Lane**
**London WC2A 1HN (GB)**

(56) References cited:
**PATENT ABSTRACTS OF JAPAN, vol. 2, no. 56, April 24, 1978, page 1417E78, TOKYO (JP)**
**ELECTRONICS; vol. 46, April 12, 1973 NEW YORK (US) T.J. SANDERS et al.: "Polysiliconfilled notch produces flat well-isolated bipolar memory" pages 117-120**
**ELECTRIC DESIGN, vol. 27, no. 14, July 1979 NEW YORK (US) D. BURSKY: "Isolation process and DEAP cut PROM access time", page 31**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to a programmable read-only memory device, and particularly relates to a programmable read-only memory device composed of shorted-junction type memory cells and peripheral circuits.

In recent years, field programmable read-only memories have been widely used in the computers and their peripheral equipment. A field programmable read-only memory (hereinafter referred to as PROM) has merit in that in the field, the user can electrically write-in data to be stored in the PROM. Generally, two types of the PROMs are used. The first of the PROMs is the shorted-junction type PROM and the second is the fuse-blown type PROM. In the shorted-junction type PROM, each memory cell is formed by two pn junctions which are connected back-to-back in series. To store data in the memory cell, one of the pn junctions is physically broken and electrically shorted. On the other hand, in the fuse-blown type of PROM, each memory cell is formed by a fuse and a pn junction connected in series. When data is to be stored in such a memory cell, the fuse is blown.

As compared to the fuse-blown type PROM, the shorted-junction type PROM has the advantage that it is easy to obtain a considerably higher density of cells and thus a highly integrated PROM. Since the memory cells in the shorted-junction type PROM are formed by two pn junctions in a form of a so-called planar structure bipolar transistor, it is possible to make each memory cell very small in size. The present invention is concerned with a PROM device of the shorted-junction type.

As will be explained in more detail hereinafter, a conventional PROM device which includes both memory cells and peripheral circuits contains a lifetime killer which is usually a metal impurity present in the bulk to limit the lifetime of charge carriers present in the bulk. Typically gold or copper are used as the metal. The metal doped semiconductor chip facilitates the recombination of holes and electrons in the bulk of the semiconductor chip. Therefore, in the conventional metal doped PROM device, the transistors which form the peripheral circuits of the PROM device can operate at high speed. Also, the memory cells in the PROM device can also operate at high speed.

However, to increase the packing density of the memory cells, it is desirable to reduce the thickness of the bulk. When the thickness of the bulk is small the p-type regions and n-type regions are shallow, and accordingly, transistors and memory cells of small size can be obtained. However, as will be explained in detail, later it is difficult to form shallow p-type regions and n-type regions in the bulk of a PROM device without impairing their electrical functions as a result of the presence of lifetime killers or metal impurities in the bulk. Further, when the p-type regions and n-type regions are shallow there is a tendency for the junction regions to be shorted accidentally during fabrication.

Japanese patent specification JP—A—53 68 182 discloses such a PROM device including both peripheral circuits and memory cells on the same semiconductor chip with the memory cells being formed by a first pn junction and a second pn junction located one above the other with both being formed in the bulk, and a metal electrode formed on the surface of the bulk adjacent the second pn junction and separated from it by a buffer layer of polycrystalline silicon. The buffer layer helps prevent short circuiting of the second pn junction during fabrication but as explained above the device includes gold impurities which act as a lifetime killer.

According to this invention, a programmable read-only memory device including both programmable read-only memory cells and peripheral circuits for co-operating with them formed as part of the same semiconductor bulk, each of the memory cells of the device comprising a first pn junction and a second pn junction located one above the other with both being formed in the bulk, a metal electrode acting as a bit line formed on the surface of the bulk, adjacent the second pn junction, a buried layer formed beneath the memory cells and acting as a word line, a buffer layer of semiconductor material introduced between the metal electrode and the surface of the bulk, the buffer layer preventing a metal-semiconductor eutectic from being formed by the electrode and the second pn junction during fabrication of the device but allowing the metal-semiconductor eutectic to be formed during programming, and isolation areas formed in the bulk to isolate each memory cell, is characterised in that no lifetime killer is present in the bulk, in that the isolation areas are in the form of V-shaped grooves with those parallel to the buried layer extending downwards beneath the buried layer and those tranverse to the buried layer extending downwards into but not through the buried layer forming the word line and in that the thickness of the regions of the bulk forming the first and second pn junctions is such that each memory cell effectively comprises a transistor in series with a diode prior to programming.

Examples of programmable read only memories in accordance with this invention will now be described and contrasted with conventional devices with reference to the accompanying drawings; in which:—

Figure 1 illustrates a conventional PROM device;

Figure 2 is a cross-section through a conventional PROM cell;

Figure 3 is a cross-section through a PROM cell in accordance with the present invention;

Figure 4A is a plan of PROM cells in accordance with the present invention;

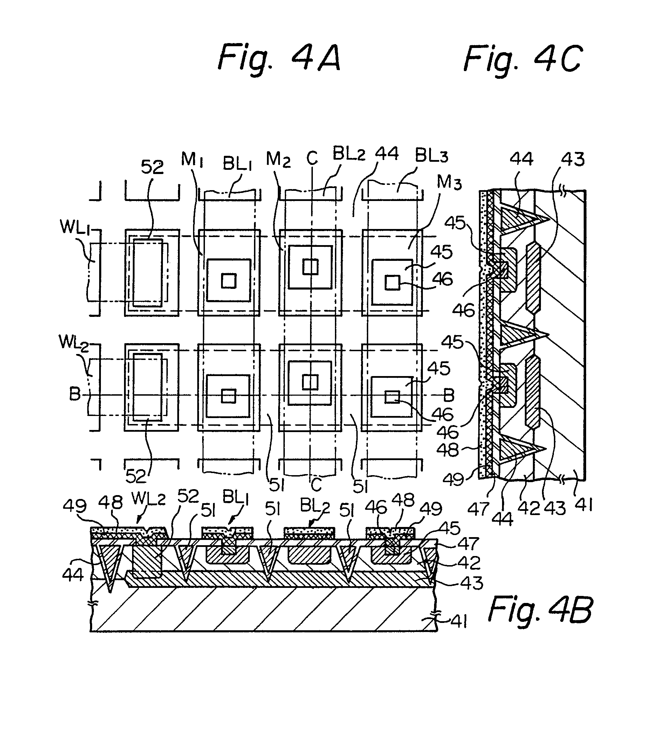

Figure 4A is a plan of PROM cells in accordance with the present invention;

Figure 4B is a cross-section taken along the line B—B in Figure 4A;

Figure 4C is a cross-section taken along the line C—C in Figure 4A;

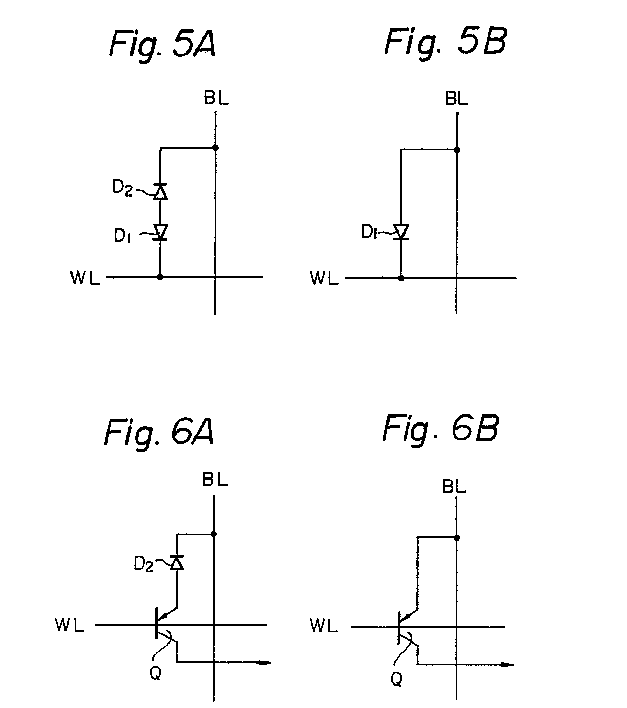

Figure 5A is an equivalent circuit diagram of a conventional PROM cell before programming;

Figure 5B is an equivalent circuit diagram of a conventional PROM cell after programming;

Figure 6A is an equivalent circuit diagram of a PROM cell according to the present invention before programming;

Figure 6B is an equivalent circuit diagram of a PROM cell according to the present invention after programming;

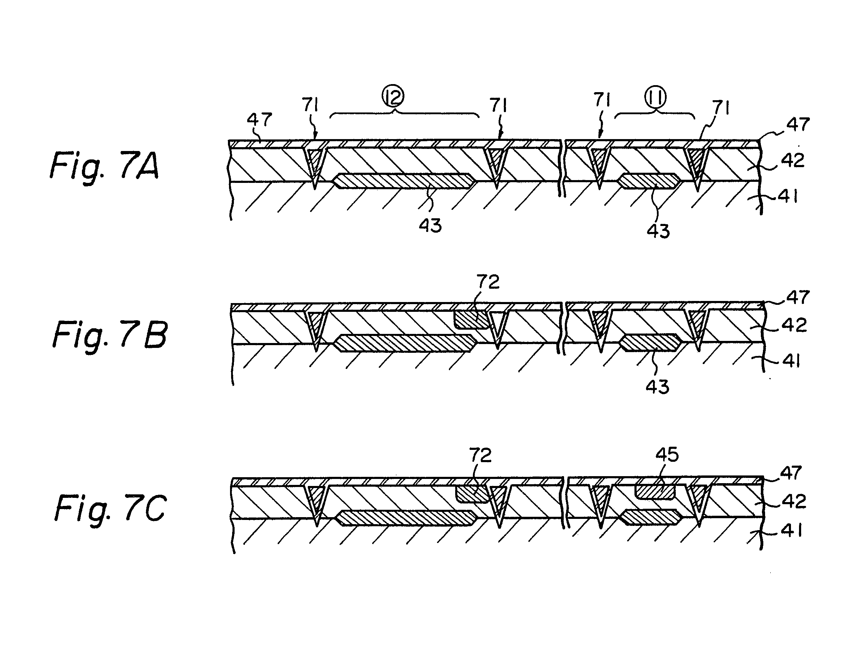

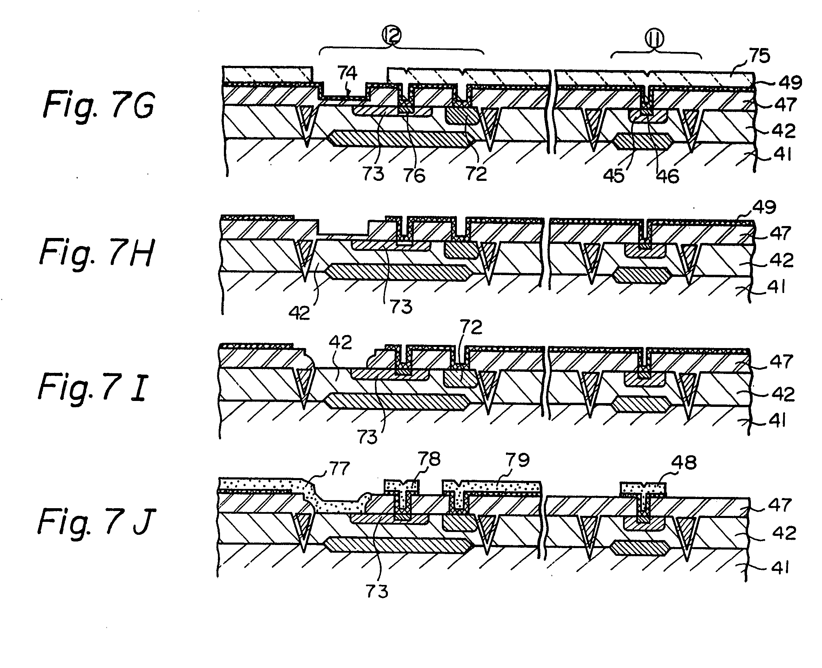

Figure 7A through 7J are cross-sections of a PROM device according to the present invention, to illustrate the process for manufacturing it.

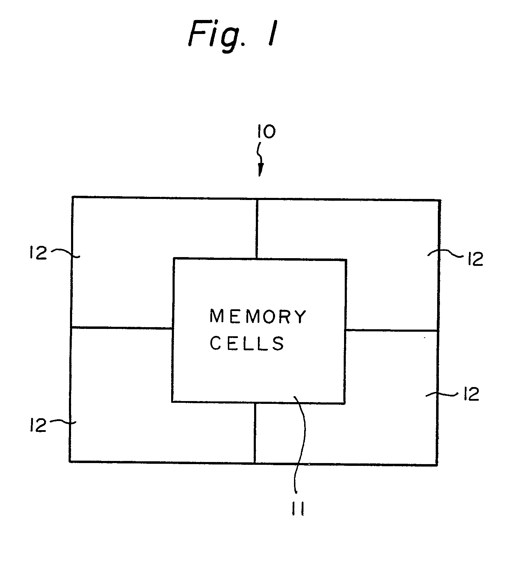

In Figure 1, which illustrates a conventional PROM device, the PROM device 10 is formed by PROM cells 11 and a plurality of peripheral circuits 12. The PROM cells 11 and the peripheral circuits 12 are formed together in and on one semiconductor chip. Data to be stored is written in memory cells 11, in the field by the user. The peripheral circuits 12 are, for example, a circuit for selecting a required memory cell, a circuit for writing data into the memory cells, a circuit for reading stored data from memory cells and so on.

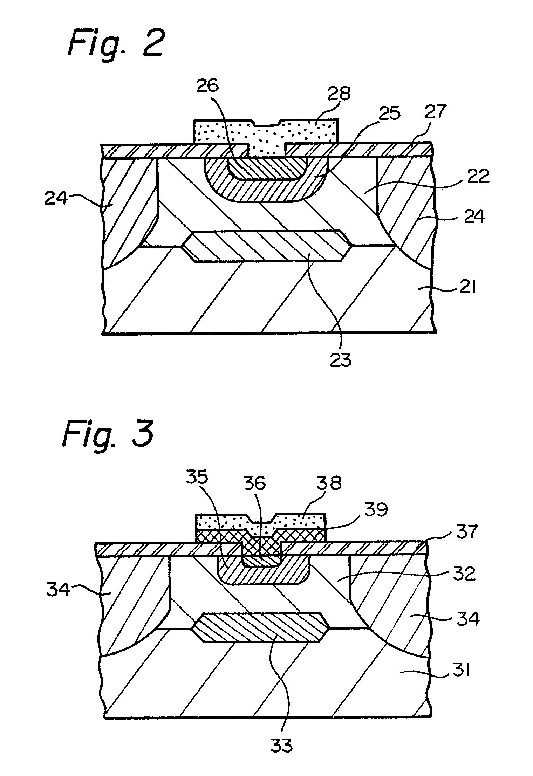

In Figure 2, which is a cross-section through one of the conventional PROM cells 11, the reference numeral 21 represents a semiconductor substrate, for example a p-type silicon semiconductor substrate. An n-type layer 22 is formed on the substrate 21. The layer 22 may be made by, for example, an epitaxial growth process. Both the substrate 21 and the layer 22 form the so-called bulk. An n+-type buried layer 23 is formed in the bulk. The reference numeral 24 represents an isolation area or isolation region which isolates the memory cell from adjacent memory cells (not shown) and peripheral circuits (not shown). In the layer 22, a p-type region 25 is formed. In the p-type region 25, an n+-type region 26 is formed. An insulation film 27 is formed on the surfaces of the bulk. An electrode 28 on the insulation film 27 electrically contacts the n+-type region 26 through a window formed in the film 27.

Thus, a shorted-junction type PROM is formed. This PROM cell, as previously mentioned, comprises two pn junctions. The first one of the two pn junctions corresponds to the pn junction between the p-type region 25 and the n-type layer 22. The second thereof is formed between the p-type region 25 and the n+-type region 26. In this case, the second pn junction (25, 26) is physically broken and electrically shorted, when data is written into this PROM cell. The shorting of the pn junction (25, 26) is achieved by applying a large write current from the electrode 28, acting as a bit line, to the n+-type buried layer 23 acting as a word line. The large write current induces a rise in temperature along the current path through the bulk. Then a reaction between the electrode 28 and the n+-type region 26 occurs, and a resultant eutectic of the metal electrode 28 and the n+-type silicon region 26 grows in the region 26. The resultant metal-silicon eutectic enters further into the p-type region 25. As a result, the second pn junction (25, 26) is physically broken and electrically shorted by the metal-silicon eutectic. Usually the metal electrode 28 is made of aluminium, because aluminium provides a good reaction with the silicon region 26 to obtain the metal-silicon eutectic rapidly.

As previously mentioned, a lifetime killer is incorporated in the semiconductor chip of a conventional PROM device which includes both memory cells and peripheral circuits. The lifetime killer is useful for increasing the operating speed of the electronic elements, such as diodes, transistors and so on, which form the PROM cells and peripheral circuits. The p-type region 25 and the n-type regions 22, 26 may be electrically shorted due to the presence of the lifetime killer which is formed by metal impurities, such as gold or copper. Accordingly, in the conventional PROM cells, it is necessary to employ a deep n-type region 26 and a deep p-type region 25 to prevent the two adjacent p-type and n-type regions from being electrically shorted. Also, in the peripheral circuits, it is necessary to use deep base regions and deep emitter regions in respective transistors to prevent the two base and emitter regions from being electrically shorted. For example, in Figure 2, the thickness of the n-type layer 22 is about 7 $\mu$m, the thickness of the p-type region 25 is about 2 $\mu$m and the thickness of the n+-type region 26 is about 1 $\mu$m. Consequently, in a conventional PROM device incorporating both memory cells and peripheral circuits it is difficult to use shallow base regions, shallow emitter regions, shallow p-type regions and shallow n-type regions, due to the presence of the lifetime killer.

To obtain a high density and a highly integrated PROM device, the semiconductor chip of the PROM device must be fabricated with shallow bases, emitters, p-type and n-type regions. When these regions are formed deeply in the bulk by a diffusion process, the diffused regions spread not only in the longitudinal directions but also spread in the lateral direction which is undesirable. As a result, each of the diffused regions occupies a larger space in the bulk than necessary. This is the reason why shallow regions must be used in the bulk, to obtain a high density and highly integrated PROM device.

As part of the present invention, shallow regions are used in the bulk of the PROM device and the life time killer is eliminated. Since there is no lifetime killer in the PROM device, the PROM cells 11, the p-type region 25, and the n+-type region 26 and the n-type layer 22 are not likely to be easily shorted with each other. The shallow regions 22, 25 and 26 in the bulk result in high density and highly integrated PROM cells being obtained but when these regions are formed shallowly, the above mentioned metal-silicon eutectic is liable to enter the p-type region 25, from the boundary between the electrode 28 and the n+-type region 26 due to the heat applied to the bulk during fabrication even though the data to be stored should not be written in the PROM cell.

On the other hand, since there is no life time killer in the bulk, the operating speed of the transistors in the peripheral circuits tends to be relatively low. Therefore, it is desirable that the peripheral circuits of the PROM device must be designed to maintain the operating speed of the transistors to be not less than that achieved in the conventional peripheral circuits. In short, a PROM device having no life time killer and having shallow regions must also satisfy the following two conditions.

That is:

(1) the metal-silicon eutectic should be suppressed from growing during the fabrication process, and

(2) the operating speed of the electronic elements should be maintained at a level as high as the level of the operating speed achieved in the conventional PROM device which includes a life time killer and other disadvantages resulting from the removal of the life time killer must also be overcome.

In Figure 3, which is a cross-section of one of the PROM cells according to the present invention, members 31 through 38 are, respectively identical to members 21 through 28 illustrated in Figure 2. The memory cell of this Figure contains no life time killer, and accordingly, shallow layer 32 and shallow regions 35 and 36 can be realised. Thus, each of the memory cells does not occupy a large space in the bulk, and accordingly, high density and highly integrated PROM cells can be obtained. However, since the depth of each of the regions 35 and 36 is shallow, the above mentioned metal-silicon eutectic is very likely to enter the region 35 via the shallow region 36. Accordingly, each memory cell may unnecessarily be broken and shorted by the heat which is applied to it during the fabrication processes. For the purpose of resolving the abovementioned problem, a buffer layer 39 is inserted between the n+-type region 36 and the metal electrode 38. Such buffer layer 39 is not found in the PROM cell of Figure 2 although it is known to use such a buffer layer in a PROM cell as shown in JP—A—52-79887. The buffer layer 39 is preferably made of a silicon semiconductor material, such as monocrystalline silicon or polycrystalline silicon. In this case, the above mentioned metal-silicon eutectic is first created in the buffer layer 39 and then enters into the region 36 by slow degrees, but does not further enter into the region 35 as long as the above mentioned write current does not flow through the electrode 38, the buffer layer 39, regions 36 and 35, the layer 32 and buried layer 33. When the write current is applied, the pn junction 35 and 36 is physically broken and electrically shorted by the metal-silicon eutectic provided from the buffer layer 39.

Since the PROM cell of Figure 3 contains no life time killer, parasitic lateral pnp transistors are created between the PROM cell of Figure 3 and adjacent PROM cells (not shown). Therefore each PROM cell is isolated from the adjacent PROM cells by means of suitable isolation areas 44 and 51. The isolation areas will be described in more detail with reference to Figures 4A to 4C and Figures 7A to 7J.

Regarding the peripheral circuits 12 (see Figure 1), the bulk contains no life time killer and thus the operating speed of the transistors which comprise the peripheral circuits are considerably reduced. However, in the present invention, shallow regions are also used in the peripheral circuits, which results in the above mentioned reduction in the operating speed being eliminated by the transistors having shallow bases and shallow emitters. The reduction of the operating speed can also be eliminated, not by employing saturation mode transistors as is the usual practice, but by employing non-saturation mode transistors. The non-saturation mode transistors can be realised by using, for example, Schottky TTL (transistor transistor logic) circuits. The Schottky TTL circuit will be clarified with reference to Figures 7A to 7J.

The actual arrangement of the PROM cells will be clarified with reference to Figs. 4A, 4B and 4C. Fig. 4A is a plan view of PROM cells to explain the actual arrangement of the PROM cells according to the present invention. Figs. 4B and 4C are cross-sectional views taken along lines B—B and C—C, shown in Fig. 4A, respectively. Referring to Figs. 4A, 4B and 4C, the PROM cells are located at respective cross points defined by word lines ($WL_1$, $WL_2$...) and bit lines ($BL_1$, $BL_2$...). The word and bit lines are arranged in a grid-like pattern. Members 41 through 49 of Figs. 4A, 4B and 4C are identical to the members 31 through 39 of Fig. 3, respectively. As previously mentioned, since a life time killer is not contained in the bulk, the parasitic lateral pnp transistors are created between each adjacent PROM cell ($M_1$, $M_2$, $M_3$...). Accordingly, the above mentioned suitable isolation areas must be inserted therebetween. The isolation areas (isolation regions) are represented by the reference numerals 44 and 51. The isolation areas 44 and 51 are formed by the following steps. Firstly, V shaped grooves are formed in the n-type layer 42; secondly, the surfaces of the V shaped grooves are covered by insulation layers, such as $SiO_2$, and lastly, poly-

crystalline semiconductor materials fill the V shaped grooves having the insulation layers thereon. The isolation areas formed by the V shaped grooves require much smaller spaces in the bulk than the isolation areas formed by conventional pn junctions. Each of the isolation areas 44 extends from the surface of the n-type layer 42 to the substrate 41. Thus, the isolation areas 44 isolate the PROM cells which are arranged along word lines, from each other. Each of the isolation areas 51 extends from the surface of the n-type layer 42 to the $n^+$-type buried layer 43. This layer 43 is not cut off by the isolation areas 51, because the layer 43 acts as a part of the word line $WL_2$. Thus, the isolation areas 51 isolate the PROM cells, which are arranged along bit lines, from each other. The depth of each of the V shaped grooves can easily be controlled by suitably determining the size of respective mouth portions of the grooves exposed on the surface of the bulk. Each of the $n^+$-type buried layers 43, located between two adjacent isolation areas 44, acts as a layer having low resistance value to be connected to respective word lines at the surface of the n-type layer 42 via a conductive region 52. Thus, each of the PROM cells ($M_1$, $M_2$, $M_3$...) which are composed of the p-type region 46 and $n^+$-type region 45, is isolated from neighboring PROM cells by the two adjacent isolation areas 44 and the two adjacent isolation areas 51, respectively, along bit lines and word lines. Each of the bit lines $BL_1$, $BL_2$, $BL_3$... is connected with corresponding one of the PROM cells located in each of the word lines $WL_1$, $WL_2$, $WL_3$....

The above mentioned parasitic lateral pnp transistors can also be diminished by arranging the PROM cells with a zig-zag pattern as illustrated in Fig. 4A. The zig-zag pattern arrangement is useful for suppressing electrical parasitic interconnection between each two adjacent PROM cells in the bulk which contains a life time killer.

If the data to be stored is written in, for example, the PROM cell $M_1$, a positive write voltage is applied to the bit line $BL_1$ and a negative write voltage is applied to the word line $WL_1$. Then, the pn junction between the regions 46 and 45 is inversely biased by said positive and negative write voltages, and the pn junction (46 and 45) is heated by the large write current. Thus, the pn junction (46 and 45) of the PROM cell $M_1$ is physically broken and electrically shorted by said metal-silicon eutectic which extends from the buffer layer 49 to the p-type region 45.

The conventional PROM cell has an equivalent circuit composed of two pn junctions, that is a first diode $D_1$ and a second diode $D_2$. The diodes $D_1$ and $D_2$ are connected in series (but have different polarities) between the word line WL and the bit line BL (see Fig. 5A). The diode $D_1$ corresponds to the pn junction between the regions 42 and 45, and the diode $D_2$ corresponds to the pn junction between the regions 45 and 46. The diode $D_1$ operates so as to block the reverse current flowing from the word line WL to the bit line BL. If the PROM cell is required to store data, the second diode $D_2$ is physically broken and electrically shorted, as illustrated in Fig. 5B, by said metal-silicon eutectic. The write current flowing from the bit line BL to the word line, is usually about 200 mA. Therefore, a conventional decoder (not shown) must have enough capacity for receiving such a large write current of 200 mA via the word line. The decoder is accommodated in the peripheral circuit 12 (Fig. 1). However, in the present invention, it is not necessary for the decoder to receive such a large write current of 200 mA. This is because, since the regions 45, 46 and the n-type layer 42 are shallow, each PROM cell is very small. It should be understood that the small PROM cell cannot accommodate a large write current flowing therethrough, and the write current can be suppressed to about 120 mA.

Further, the shallower the regions 45, 46 and the n-type layer 42 are, the more the current to be received by said decoder can be reduced. The reason for this will be clarified with reference to Figs. 6A and 6B. Fig. 6A is an equivalent circuit diagram of the pre-programming PROM cell having very shallow regions 45, 46 and an n-type layer 42. Fig. 6B is an equivalent circuit diagram of the post-programming PROM cell. Referring to Figs. 6A and 6B, the reference symbol Q represents a vertical pnp transistor. The construction of this transistor Q may be clarified with reference to Fig. 4C. In Fig. 4C, since the n-type layer 42 is very shallow, the write current flows from the bit line (48) to the decoder, not only through the $n^+$-type buried layer 43 but also through the substrate 41. Accordingly, the p-type region 45 forms the emitter of the transistor Q (Figs. 6A and 6B), the n-type layer 42 forms the base thereof and the p-type substrate 41 forms the collector thereof. The base of the transistor Q is also electrically connected to the $n^+$-type buried layer 43 acting as a part of the word line WL. Returning to Figs. 6A and 6B, the greatest part of the write current of about 120 mA flows through the emitter and collector of the transistor Q. Accordingly, very small write current being equal to $I_w/\beta$ is supplied to the decoder via the word line WL, where the symbol $I_w$ denotes the amplitude of the write current and the symbol $\beta$ denotes the current amplification factor of the transistor Q. The current amplification factor $\beta$ is about 30. Therefore, the decoder receives a very small write current of about 4 (120/30) mA. Thus, the decoder can be fabricated by very small size diodes, transistors and other electronic elements.

Figs. 7A through 7J are cross sectional views to explain the sequential processes for fabricating the PROM device according to the present invention. In each of these Figures, the

right portion ⑪ corresponds to the PROM cells area (see the area 11 in Fig. 1), the left hand portion ⑫ corresponds to the peripheral circuits area (see the areas 12 in Fig. 1). In the first process (Fig. 7A), the n-type layer 42 and the $n^+$-type buried layer 43 are formed on the p-type silicon semiconductor substrate 41. Also, isolation areas (isolation regions) 71 (corresponding to the member 44 or 51 in Figs. 4A, 4B and 4C) are formed. The surface of the bulk is covered by the insulation film 47 made of silicon dioxide ($SiO_2$). The thickness of the layer 42 is about 3 $\mu m$, and the thickness of the insulation film 47 is about 1500 Å.

In the second process (Fig. 7B, an $n^+$-type region 72 is formed. The region 72 acts as a collector contact region of the transistor which will be created in the following processes, which transistor comprises a part of the peripheral circuit. The region 72 may be made by an ion injection of phosphide or arsenic through a suitable mask made of, for example, a photoresist and also heating process which follows after said ion injection, in an atmosphere filled with nitride gas.

In the third process (Fig. 7C), the p-type region 45 is formed, which region 45 and the n-type layer 42 create the first pn junction of the PROM cell. The region 45 may be made by an ion injection of boron (B) through a suitable mask made of, for example, a photoresist, and also by a heating process which follows after said ion injection, in an atmosphere filled with nitride gas.

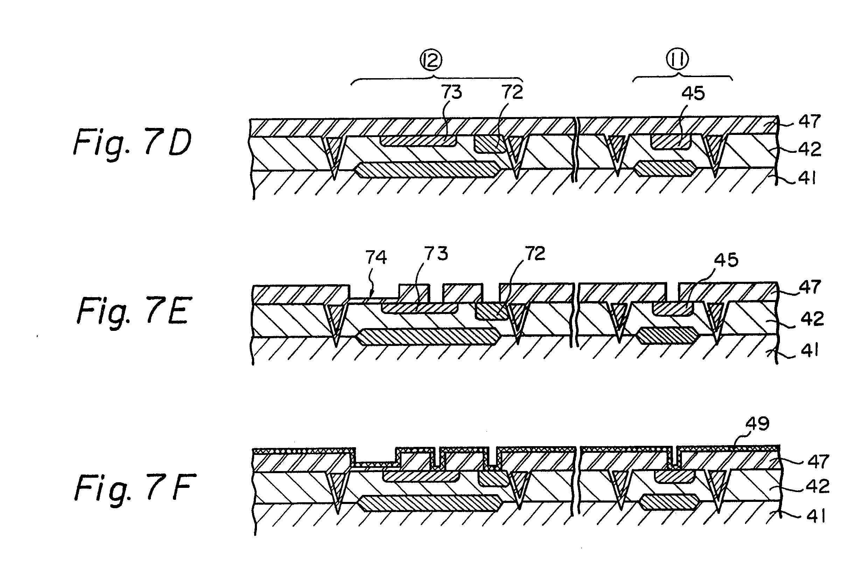

In the fourth process (Fig. 7D), a p-type region 73 is formed. The region 73 acts as a base of said transistor which will be completed in the following process. The region 73 may also be made by an ion injection of boron through a suitable mask made of, for example, a photo resist, and also by a heating process which follows after said ion injection, in an atmosphere filled with nitride gas. It should be noted that the insulation film 47 made of $SiO_2$ is also made during said heating process. Thus, the insulation film 47 becomes 3000∿4000 Å in thickness. In this case, the thickness of the p-type region 45 becomes about 1.2 $\mu m$, and the thickness of the p-type region 73 becomes about 1.0 $\mu m$. Since the process for making the region 73 begins after the process for making the region 45, the region 73 is shallower than the region 45. It is preferable to further increase the thickness of the insulation film 47 through a chemical vapor deposition (CVD) process, so that the capacitance value of the parasitic capacitor developed in the film 47, may be reduced. The capacitance value obtained by the electrode located on the film 47 and the bulk lying beneath the film 47 should always be small in order to obtain high operating speed.

In the fifth process (Fig. 7E), windows are formed in the insulation film 47 at the portions right above the regions 45, 72 and 73. In this case, a recess 74 is also formed in the film 47, by using a selective etching such as a photo etching or a plasma etching.

In the sixth process (Fig. 7F), the buffer layer 49 is grown on the entire surface of the semiconductor chip. The buffer layer 49 being 1 $\mu m$ thick is made of polycrystalline silicon and also monocrystalline silicon. The polycrystalline silicon is grown on the film 47 made of $SiO_2$ and the monocrystalline silicon grows on the n-type layer 42, during a heating decomposition process using monosilane ($SiH_4$). The buffer layer 49 is one of the important features of the present invention (refer to the layer 39 in Fig. 3).

In the seventh process (Fig. 7G), phosphosilicate glass (PSG) is covered over the surface of the semiconductor chip, except for the area located at and around the recess 74. The phosphorus contained in the PSG 75 enters into the n-type layer 42, via the buffer layer 49, so that the $n^+$-type region 46 and a $n^+$-type region 76 are formed, respectively in the p-type region 45 and the p-type region 73. The $n^+$-type region 46 and the p-type region 45 provide the second pn junction of the PROM cell. The $n^+$-type region 76 acts as an emitter of said transistor. Thus, one of the transistors in the peripheral circuit is made. In this seventh process, it is important to note that said buffer layer 49 also produces another advantage. If no such buffer layer 49 exists, the phosphorus of the PSG 75 would enter smoothly and deeply into the p-type regions 45 and 73. Therefore, it is impossible to obtain shallow p-type regions 45 and 73. However, in the seventh process, it is easy to obtain shallow p-type regions 45 and 73, because the buffer layer 49 prevents the phosphorus from entering into these regions smoothly and deeply. Thus, shallow regions are formed in the bulk.

The PSG 75 may be made through a vapor phase reaction process using monosilane ($SiH_4$), phosphine ($PH_4$) and oxygen ($O_2$). The recess 74 of the PSG 75 may be formed by a photo etching.

In the eighth and ninth processes (Figs. 7H and 7I), the PSG 75 are all removed from the semiconductor chip, and then the buffer layer 49 and the insulation layer 47 are selectively removed therefrom so as to form a window in the insulation layer 47 and to expose the layer 42 and the p-type layer 73. The buffer layer 42 and the p-type layer may be removed selectively through a plasma etching process. As previously mentioned, since the bulk contains no life time killer, the operating speed of each transistor in the peripheral circuit ⑫ is reduced. However, in the PROM device of present invention, the reduction of the operation speed is not performed by introducing the aforesaid schottky TTL circuit. Therefore, the pn junction between the n-type layer 42 and the p-type layer 73 is exposed on the surface of the bulk so as to directly contact with a metal. The metal is covered on the exposed area, which metal acts as a base electrode 77 of the transistor comprising a part of the schottky TTL circuit. Thus, the base electrode 77 performs, on one hand, ohmic contact with the base region (73), and, on the other hand, a schottky barrier contact with the collector region (42). A metal electrode 78 acts as an emitter electrode and a metal electrode 79 acts as a collector electrode. The metal electrode 48 acts as a bit line (BL) of the PROM cell. These metal electrodes are made of aluminum, titanium-aluminum alloy or titanium-tungsten-aluminum alloy.

As explained above in detail, the PROM device of the present invention is the metal-free PROM device, in which metal acts as the life time killer. Accordingly, shallow regions can be formed in the bulk, thereby a high density and highly integrated PROM device can be realized.

**Claims**

1. A programmable read-only memory device including both programmable read-only memory cells and peripheral circuits for co-operating with them formed as part of the same semiconductor bulk, each of the memory cells of the device comprising a first pn junction (45, 42) and a second pn junction (45, 46) located one above the other with both being formed in the bulk, a metal electrode (48) acting as a bit line (BL) formed on the surface of the bulk (41, 42), adjacent the second pn junction (45, 46), a buried layer (43) formed beneath the memory cells and acting as a word line (WL), a buffer layer (49) of semiconductor material introduced between the metal electrode (48) and the surface of the bulk (41, 42), the buffer layer (49) preventing a metal-semiconductor eutectic from being formed by the electrode (48) and the second pn junction (45, 46) during fabrication of the device but allowing the metal-semiconductor eutectic to be formed during programming, and isolation areas formed in the bulk to isolate each memory cell, characterised in that no lifetime killer is present in the bulk (41, 42), in that the isolation areas (44, 51) are in the form of V-shaped grooves with those (44) parallel to the buried layer extending downwards beneath the buried layer (43) and those (51) transverse to the buried layer (43 extending downwards into but not through the buried layer (43) forming the word line (WL), and in that the thickness of the regions of the bulk forming the first and second pn junctions (45, 42; 45, 46) is such that each memory cell effectively comprises a transistor in series with a diode prior to programming.

2. A device according to claim 1, in which the semiconductor bulk is formed by a silicon substrate (41) with an epitaxial layer (42) formed on it.

3. A device according to claim 1 or 2, in which the peripheral circuits are fabricated as Schottky transistor transistor logic circuits.

4. A device according to any one of the preceding claims, in which the buffer layer (49) includes polycrystalline silicon.

5. A device according to claim 4, in which the buffer layer (49) also includes monocrystalline silicon.

6. A device according to any one of the preceding claims, in which the second pn junction (45, 46) is completed by introducing impurities into the bulk through the buffer layer (49).

7. A device according to any one of the preceding claims, wherein the semiconductor bulk is formed by a silicon substrate (41) with an epitaxial layer (42), the V-shaped grooves (51) transverse to the buried layer (43) extending not lower than the bottom of the epitaxial layer (42).

8. A device according to any of the preceding claims, wherein the memory cells are arranged in a zig-zag pattern.

**Patentansprüche**

1. Programmierbare Nur-Lese-Speichervorrichtung, welche sowohl programmierbare Nur-Lese-Speicherzellen als auch periphere Schaltungen zur Kooperation mit diesen umfaßt, welche als Teil derselben Halbleitermasse ausgebildet sind, wobei jede der Speicherzellen der Vorrichtung einen ersten pn-Übergang (45, 42) und einen zweiten pn-Übergang (45, 46) umfaßt, welche übereinander angeordnet sind und beide in dem Grundmaterial ausgebildet sind, mit einer Metallelektrode (48), welche als Bitleitung (BL) wirkt und auf der Oberfläche des Grundmaterials (41, 42) neben dem zweiten pn-Übergang (45, 46) ausgebildet ist, mit einer vergrabenen Schicht (43), welche unter den Speicherzellen ausgebildet ist und als Wortleitung (WL) wirkt, mit einer Pufferschicht (49) aus Hauptleitermaterial, welche zwischen der Metallelektrode (48) und der Oberfläche des Grundmaterials (41, 42) eingeführt ist, und die verhindert, daß ein Metall-HalbleiterEutektikum durch die Elektrode (48) und den zweiten pn-Übergang (45, 46) während der Herstellung der Vorrichtung gebildet wird, welche jedoch zuläßt, daß ein Metall-Halbleiter-Eutektikum während der Programmierung gebildet wird, und mit Isolationsbereichen, welche in dem Grundmaterial ausgebildet sind, um jede Speicherzelle zu isolieren, dadurch gekennzeichnet, daß kein Lebenszeittöter in dem Grundmaterial (41, 42) vorhanden ist, daß die Isolationsbereiche (44, 51) als V-förmige Nuten ausgebildet sind, von denen diejenigen (44), welche parallel zu der Vergrabenen Schicht verlaufen, sich nach unten bis unter die vergrabene Schicht (43) erstrecken, und diejenigen (51), welche quer zu der vergrabenen Schicht (43) verlaufen, sich nach unten in die vergrabene Schicht (43), welche die Wortleitung (WL) bildet, hinein aber nicht durch diese hindurch erstrecken, und daß die Dicke der Bereiche des Grundmaterials, welche die ersten und die zweiten pn-Übergänge (45, 42; 45, 46) bilden, derart ist, daß jede Speicherzelle vor der Programmierung effektiv einen Transistor in Reihen mit einer Diode umfaßt.

2. Vorrichtung nach Anspruch 1, bei welcher die Halbleitermasse von einem Siliziumsubstrat (41) mit einer darauf ausgebildeten epitaktischen Schicht (42) gebildet ist.

3. Vorrichtung nach Anspruch 1 oder 2, bei welcher die peripheren Schaltungen als Schottky - Transistor - Transistor - Logikschaltungen hergestellt sind.

4. Vorrichtung nach einem der vorhergehenden Ansprüche, bei welcher die Pufferschicht (49) polykristallines Silizium umfaßt.

5. Vorrichtung nach Anspruch 4, bei welcher die Pufferschicht (49) auch monokristallines Silizium umfaßt.

6. Vorrichtung nach einem der vorhergehenden Ansprüche, bei welcher der zweite pn-Übergang (45, 46) durch Einführung von Verunreinigungen durch die Pufferschicht (49) in das Grundmaterial vervollständigt ist.

7. Vorrichtung nach einem der vorhergehenden Ansprüche, bei welchem die Halbleitermasse durch ein Siliziumsubstrat (41) mit einer epitaktischen Schicht (42) gebildet ist, und die V-förmigen Nuten (51), welche quer zu der vergrabenen Schicht (43) verlaufen, sich nicht tiefer als der Boden der epitaktischen Schicht (42) erstrecken.

8. Vorrichtung nach einem der vorhergehenden Ansprüche, bei welcher die Speicherzellen in einem Zick-Zack-Muster angeordnet sind.

## Revendications

1. Mémoire morte programmable comprenant à la fois des cellules de stockage et des circuits périphériques destinés à coopérer avec les cellules et faisant partie de la massue ou corps de semiconducteur, chaque cellule étant constituée d'une première jonction pn (45, 42) et d'une seconde jonction pn (45, 46) situées l'une au-dessus de l'autre et formées toutes deux dans le corps, une électrode métallique (48) agissant comme une ligne de bits (BL) étant formée sur la surface du corps (41, 42) près de la seconde jonction (45, 46), une couche enterrée (43) formée sous les cellules agissant comme une ligne de mots (WL), une couche tampon (49) de matériau semi-conducteur étant intercalée entre l'électrode métallique (48) et la surface du corps (41, 42), la couche tampon (49) empêchant qu'un eutectique métal-semi-conducteur na soit formé par l'électrode (48) et la seconde jonction pn (45, 46) pendant la fabrication de la mémoire maise permettant la formation de cet eutectique pendant la programmation, des zones d'isolement étant formées dans le corps pour isoler chaque cellule de stockage, caractérisée en ce que le corps (41, 42) ne contient pas de limiteur de vie pour réduire la durée de vie des porteurs, que les zones d'isolement (44, 51) ont la forme de sillons en V, dont ceux (44) qui sont parallèles à la couche enterrée s'etendent vers le bas jusque sous la couche enterrée (43) et dont ceux qui sont transversaux à la couche enterrée (43) s'étendent vers le bas mais sans traverser la couche enterrée (43) formant la ligne de mots (WL), et que l'épaisseur des régions du corps formant la première et la seconde jonction pn (45, 42; 45, 46) est telle que chaque cellule de stockage est constituée en fait d'une transistor en série avec une diode avant la programmation.

2. Mémoire selon la revendication 1, dont la masse ou corps de semi-conducteur est formé par un substrat de silicium (41) sur lequel est formée une couche épitaxiale (42).

3. Mémoire selon la revendication 1 ou 2, dont les circuits périphériques sont réalisés comme des circuits de logique transistor-transistor (TTL) du type Schottky.

4. Mémoire selon l'une quelconque des revendications précédentes, dont la couche tampon (49) comporte du silicium polycristallin.

5. Mémoire selon la revendication 4, dont la couche tampon (49) comporte également du silicium monocristalline.

6. Mémoire selon l'une quelconque des revendications précédentes, dans laquelle la seconde jonction pn (45, 46) est complétée par l'introduction d'impuretés dans le corps à travers le couche tampon (49).

7. Mémoire selon l'une quelconque des revendications précédentes, dont la masse ou corps de semi-conducteur est formé par un substrate de silicium (41) avec une couche épitaxiale (42) et dans lequel des sillons en V (51) transversaux à la couche enterrée (43) ne s'étendent pas plus bas que le côté inférieur de la couche épitaxiale (42).

8. Mémoire selon l'une quelconque des revendications précédentes, caractérisée en ce que les cellules de stockage sont disposées en zig zag.

# Fig. 1

10

12

12

MEMORY
CELLS

12

12

11

## Fig. 2

## Fig. 3

## Fig. 4A          Fig. 4C

Fig. 4B

*Fig. 5A*

*Fig. 5B*

*Fig. 6A*

*Fig. 6B*

Fig. 7A

Fig. 7B

Fig. 7C

0 018 173

Fig. 7D

Fig. 7E

Fig. 7F

0 018 173

Fig. 7G

Fig. 7H

Fig. 7 I

Fig. 7 J

0 018 173